# EUROPÄISCHE PATENTSCHRIFT

(11) **EP 3 019 640 B1**
(45) Veröffentlichungstag und Bekanntmachung des Hinweises auf die Patenterteilung: **08.01.2020**
(21) Anmeldenummer: 14739679.0
(22) Anmeldetag: 09.07.2014
(51) Int. Cl.: C23C 14/08, C23C 14/34, C23C 14/00, C23C 14/35, H01J 37/34

(54) **TARGET ZUR REAKTIVEN SPUTTER-ABSCHEIDUNG ELEKTRISCH-ISOLIERENDER SCHICHTEN**
TARGET FOR THE REACTIVE SPUTTER DEPOSITION OF ELECTRICALLY INSULATING LAYERS
CIBLE DE DÉPÔT DE COUCHES ÉLECTRIQUEMENT ISOLANTES PAR PULVÉRISATION CATHODIQUE RÉACTIVE

(30) Priorität: 09.07.2013 US 201361843998 P
(43) Veröffentlichungstag der Anmeldung: 18.05.2016
(73) Patentinhaber: Oerlikon Surface Solutions AG, Pfäffikon, 8808 Pfäffikon SZ (CH)
(72) Erfinder: HAGMANN, Juerg, CH-9468 Sax (CH); KRASSNITZER, Siegfried, A-6800 Feldkirch (AT)
(74) Vertreter: Misselhorn, Hein-Martin
(86) Internationale Anmeldenummer: PCT/EP2014/001884
(87) Internationale Veröffentlichungsnummer: WO 2015/003806

(56) Entgegenhaltungen:
- JP-A- S60 131 965
- JP-A- 2004 269 939
- US-A- 5 466 355
- US-A1- 2003 066 748
- US-A1- 2006 137 969
- US-A1- 2009 139 862
- US-A1- 2010 025 229

## Beschreibung

Die vorliegende Erfindung betrifft ein Target, dessen Targetoberfläche derart gestaltet ist, dass durch die Verwendung des besagten Targets für reaktive Sputter-Abscheidung von elektrisch isolierenden Schichten in einer Beschichtungskammer eine Ausbildung einer Funkelentladung von der Targetoberfläche zu einer Anode, welche sich auch in der Beschichtungskammer befindet, vermieden wird.

### Stand der Technik

Beschichtungsprozesse unter Verwendung von Sputter-Techniken (nachfolgend werden auch Begriffe wie Sputterprozesse, HiPIMS-Prozesse und Sputter-Abscheidung verwendet, wobei alle diese Prozesse als Beschichtungsprozesse unter Verwendung von Sputter-Techniken zu verstehen sind) werden in Vakuumbeschichtungskammern unter Verwendung mindestens eines sogenannten Targets durchgeführt, welches durch das Anlegen einer negativen Spannung mittels einer Spanungs- oder Leistungsversorgung als Kathode geschaltet wird. Beim Sputterprozess wird mindestens eine zusätzliche Elektrode, die sich auch in der Beschichtungskammer befindet, als Anode geschaltet. Ein sogenanntes Arbeitsgas, welches in der Regel ein Edelgas ist, wird in die Beschichtungskammer eingelassen und aus dem werden positiv geladene Ionen generiert. Die positiv-geladenen Arbeitsgasionen werden zur Targetoberfläche derart beschleunigt, dass durch Stösse mit den beschleunigten Ionen Partikeln aus der Oberfläche des Targets ausgelöst werden. In Abhängigkeit von Prozessparametern werden die aus dem Target ausgelösten Partikeln in einem gewissen Anteil ionisiert und schlagen sich auf den zu beschichtenden Substratoberflächen nieder. Wenn man metallische Targets verwendet, werden die während des Sputterprozesses aus dem Target generierten Ionen oft metallische Ionen genannt. Argon wird üblicherweise, aber nicht unbedingt ausschliesslich, als Arbeitsgas verwendet.

Wenn man nicht metallische Schichten aus metallischen Targets mittels Sputterprozessen abscheiden möchte, kann man ein sogenanntes Reaktivgas in die Beschichtungskammer einlassen, welches mit den aus dem metallischen Target generierten metallischen Ionen reagieren kann. Auf diese Weise wird das aus der Reaktion zwischen dem Reaktivgas und den aus dem Target generierten Ionen resultierende Material auf die zu beschichtenden Substratoberflächen als dünne Schicht aufgebracht.

Durch die Verwendung von metallischen Targets und durch Zugabe von reaktiven Gasen wie O₂, N₂, C₂H₂, CH₄ um einige zu nennen, kommt es dann auf der Substratoberfläche zu einer Reaktion und Bildung von entsprechenden Verbundmaterialien wie Oxiden, Nitriden, Carbiden oder eine Mischung derselben, zu denen beispielsweise Oxinitriden, Carbonitriden und Carboxinitriden gehören.

Durch Streuvorgänge am Umgebungsgas innerhalb der Beschichtungskammer, sowie auch durch elektrische oder elektromagnetische Anziehungskräfte können die bereits aus dem Target gesputterten Partikeln und ionisierten Atome wieder auf das Target zurückgeleitet werden. Im Kontext der vorliegenden Erfindung wird dieses Phänomenon "Redeposition" genannt. Das passiert im besonderen Mass an den Rändern des Targets, weil dort die Sputter-Rate im Vergleich mit anderen Targetoberflächenbereichen sehr gering ist. Redeposition ist aber im Allgemeinen im grossen Mass zu erwarten in allen Bereichen der Targetoberfläche mit geringer Sputter-Rate, wie z.B., ausserhalb des Racetracks.

Die Partikeln, im Besonderen die ionisierten Atome, welche durch die sogenannte "Redeposition" auf die Targetoberfläche zurückkehren, können mit Reaktivgas reagieren und dabei einen Film aus einem durch die Reaktion resultierendes Verbundmaterial bilden, welcher insbesondere die Targetoberflächebereiche mit erhöhter "Redeposition" schneller deckt.

Wenn das durch die Reaktion resultierende Verbundmaterial ein elektrisch nicht gut leitendes Material ist, wird auf der Targetoberfläche ein elektrisch-isolierender Film gebildet, wie z.B. ein Oxid Film, der früher oder später eine Funkenentladungsproblematik auslösen kann.

Die Bildung des isolierenden Belages am z.B. Target Rand führt zu Ladungsaufbau zwischen Belag-Oberfläche und Sputter-Target und in weiterer Folge zu einem elektrischen Durchschlag und damit zur Ausbildung einer Funkenentladung von der Targetoberfläche zur Anode. Die Ausbildung von Funkenentladungen kann den gesamten Sputterprozess destabilisieren und dabei auch unerwünschte Defekte in der Schichtstruktur erzeugen.

In der Patentschrift EP0692138B1 wird ein reaktiver Sputterprozess stabilisiert, indem die am Target angelegte negative Spannung für 1 bis 10 Mikrosekunden umgepolt wird. Dabei soll die umgepolte Spannung 5 bis 20 Prozent der negativen Spannung betragen. Dadurch sollte man die Entladung bei einem reaktiven Sputterprozess gut stabilisieren können. Jedoch diese Lösung ist bei der reaktiven Sputter-Abscheidung von manchen Verbundmaterialien wie z.B. Aluminiumoxid nicht zufriedenstellend, weil solche Materialien so hoch elektrisch isolierend sind, dass wenn ein solcher Film z.B. ein Aluminiumoxidfilm auf der Targetoberfläche gebildet wird, der Prozess derart instabil wird, dass diese Massnahme für die Stabilisierung des Prozesses nicht mehr ausreichend ist.

In der Offenlegungsschrift WO99/63128 wird eine Target-Gestaltung mit abgewinkelten Rändern offenbart, welche zur Verringerung von Belegungen der Target Ränder mit Schichtmaterial dienen soll. Durch diese Lösung soll eine "Redeposition" von Partikeln auf die Target Randzone vermieden oder zumindest verzögert werden. Obwohl die Belegung der Target Ränder mit Schichtmaterial durch diese Massnahme verzögert werden kann, birgt jedoch jegliche Bildung von Filmen aus sehr elektrisch-isolierenden Verbundmaterialien immer noch die Gefahr von Funkenentladungen, insbesondere von Target Rändern zur Anode, was beispielweise im Falle von reaktiver Sputter-Abscheidung von Aluminiumoxidschichten oft vorkommt. In der Patentschrift US 2009/0139862 A1 wird ein Sputtertarget mit zwei Materialien offenbart.

Die oben beschriebene Funkenentladung-Problematik ist besonders gross bei der Abscheidung von Aluminiumoxidschichten mittels eines reaktiven High Power Impulse Sputtering (HiPIMS) Prozesses, bei dem man metallische Targets aus Aluminium und Sauerstoff als Reaktivgas verwendet.

Im Sinne der vorliegenden Erfindung wird die Bezeichnung HiPIMS Prozesse verwendet, wenn man auf Sputterprozesse hinweisen möchte, bei denen eine Stromdichte der Sputterentladung von mindestens 0.2A/cm² oder grösser 0.2A/cm², oder eine Leistungsdichte von mindestens 100W/cm² oder grösser 100W/cm² verwendet.

### Aufgabe der vorliegenden Erfindung

Es ist Aufgabe der vorliegenden Erfindung eine Lösung bereitzustellen, wodurch Prozessinstabilitäten vermieden werden können, welche aufgrund von Ausbildungen von Funkenentladungen zwischen Target und Anode bei der Abscheidung von elektrisch-isolierenden Schichten mittels reaktiver Sputtering-Prozesse auftreten können. Es ist auch gewünscht, dass die Lösung gemäss der vorliegenden Erfindung ermöglichen kann, elektrisch-isolierende Aluminiumoxidschichten mittels reaktiver HiPIMS-Prozesse unter Verwendung von metallischen Aluminium-Targets und Sauerstoff als Reaktivgas prozessstabil abzuscheiden.

### Beschreibung der vorliegenden Erfindung

Die Aufgabe der vorliegenden Erfindung wird dadurch gelöst, indem ein Target mit einer Gestaltung wie im Anspruch 1 beschrieben bereitgestellt wird und zur Durchführung von reaktiven Sputterprozessen, insbesondere von reaktiven HiPIMS-Prozessen verwendet wird.

Die vorliegende Erfindung betrifft ein Target, dessen Targetoberfläche derart gestaltet ist, dass durch die Verwendung des besagten Targets für reaktive Sputter-Abscheidung von elektrisch isolierenden Schichten in einer Beschichtungskammer, eine Ausbildung einer Funkelentladung von der Targetoberfläche zu einer Anode, welche sich auch in der Beschichtungskammer befindet, vermieden wird.

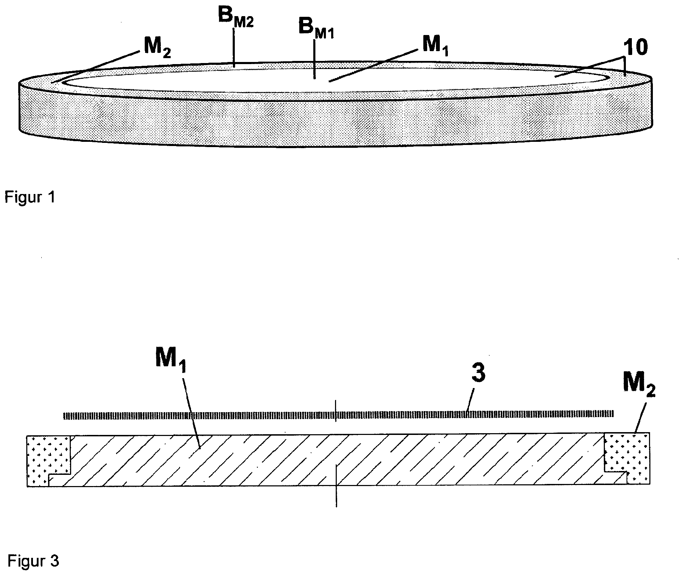

Ein Target ist in der Figur 1 schematisch gezeichnet und umfasst mindestens im Oberflächenbereich **10** mindestens einen ersten Bereich **B_{M1}** und einen zweiten Bereich **B_{M2},** wobei,
- der erste Bereich **B_{M1}** aus einem ersten Material **M₁** gebildet ist, welches aus einem Element oder mehreren Elementen besteht, welche mit einem Reaktivgas derart reagieren können, dass das aus der Reaktion resultierende M₁-umfassende Verbundmaterial die Zusammensetzung der zur Beschichtung der zu beschichtenden Substrate gewünschten Schichtmaterial entspricht, und
- der zweite Bereich **B_{M2}** aus einem zweiten Material **M₂** gebildet ist, welches aus einem Element oder mehreren Elementen besteht, welche gegenüber dem oben erwähnten Reaktivgas inert sind, oder mit dem oben erwähnten Reaktivgas derart reagieren können, dass das aus der Reaktion resultierende M₂-umfassende Verbundmaterial eine höhere elektrische Leitfähigkeit im Vergleich mit dem M₁-umfassenden Verbundmaterial aufweist, und
- **M₁** ≠ **M₂.**

Vorzugsweise ist der erste Bereich **B_{M1}** ein Bereich des Targets, welcher Bereiche der Targetoberfläche umfasst, welche eine hohe Erosionsrate durch das Sputtern von Partikeln aus dem Target ausgesetzt sind. Damit sind insbesondere Bereiche der Targetoberfläche gemeint, wo eine Racetrack zu erwarten ist. Da die Lage einer Racetrack auf der Targetoberfläche von verschieden Prozessparametern abhängig ist, vor allem von den Magnetfeldeigenschaften am Target aber auch z.B. von der Targetgeometrie, kann der erste Bereich **B_{M1}** im Sinne der vorliegenden Erfindung abhängig von den entsprechenden Prozessparametern und Prozessbedingungen ausgewählt werden.

Vorzugsweise ist der zweite Bereich **B_{M2}** ein Bereich des Targets, welcher Bereiche der Targetoberfläche umfasst, welche einer niedrigen Erosionsrate durch das Sputtern von Partikeln aus dem Target ausgesetzt sind. Damit sind insbesondere Bereiche der Targetoberfläche gemeint, wo keine Racetrack zu erwarten ist. In ähnlicher Weise wie beim Auswählen des ersten Bereiches **B_{M1}** kann der zweite Bereich **B_{M2}** im Sinne der vorliegenden Erfindung abhängig von den entsprechenden Prozessparametern und Prozessbedingungen ausgewählt werden.

Vorzugsweise umfasst der erste Bereich **B_{M1}** den Kernbereich des Targets, wie beispielweise in Fig. 1 gezeigt.

Vorzugsweise umfasst der zweite Bereich **B_{M2}** den Randbereich des Targets, wie beispielweise in Fig. 1 gezeigt.

Vorzugsweise wird das zweite Material **M₂** so ausgewählt, dass sowohl **M₂** als auch das aus der Reaktion resultierende M₂-umfassenden Verbundmaterial eine elektrische Leitfähigkeit aufweist, welche hoch genug ist, um Ausbildungen von Funkenentladungen zwischen dem Randbereich der Targetoberfläche und einer Anode in der Beschichtungskammer zu vermeiden, oder vorzugsweise ganz zu verhindern.

Gemäss einer bevorzugten Ausführungsform der vorliegenden Erfindung umfasst das zweite Material **M₂** mindestens ein Element, welches auch im ersten Material **M₁** enthalten ist.

Gemäss noch einer bevorzugten Ausführungsform der vorliegenden Erfindung enthält das erste Material **M₁** ein Metall oder eine Kombination von Metallen. Für manche Beschichtungsprozesse ist es von Vorteil, wenn das erste Material **M₁** aus einem Metall oder aus einer Kombination von Metallen besteht.

Gemäss einer weiteren bevorzugten Ausführungsform der vorliegenden Erfindung enthält das zweite Material **M₂** ein Metall oder eine Kombination von Metallen. Für manche Beschichtungsprozesse ist es von Vorteil, wenn das zweite Material **M₂** aus einem Metall oder aus einer Kombination von Metallen besteht.

Die vorliegende Erfindung wird anschliessend anhand von Beispielen und Figuren näher beschrieben:
Unter Verwendung von Sauerstoff als Reaktivgas und Aluminium umfassenden Targets haben die Erfinder mehrere Beschichtungsversuche an einer High Power Impuls Magnetron Sputter Beschichtungsanlage der Type Ingenia S3p™ von der Firma Oerlikon Balzers durchgeführt.

Zur Untersuchung der Prozessstabilität bei der HiPIMS-Abscheidung von Oxidschichten unter Sauerstoffatmosphäre wurden Targets mit unterschiedlichem Chromgehalt getestet. Dabei ergab sich eine geringere Neigung zur Funkenentladung bei steigendem Chromgehalt. Die Erfinder denken, dass eine Erklärung dafür in der Verringerung des elektrisch isolierenden Charakters der bei erhöhtem Chrom-Gehalt abgeschiedenen Aluminiumchromoxidschichten liegt.

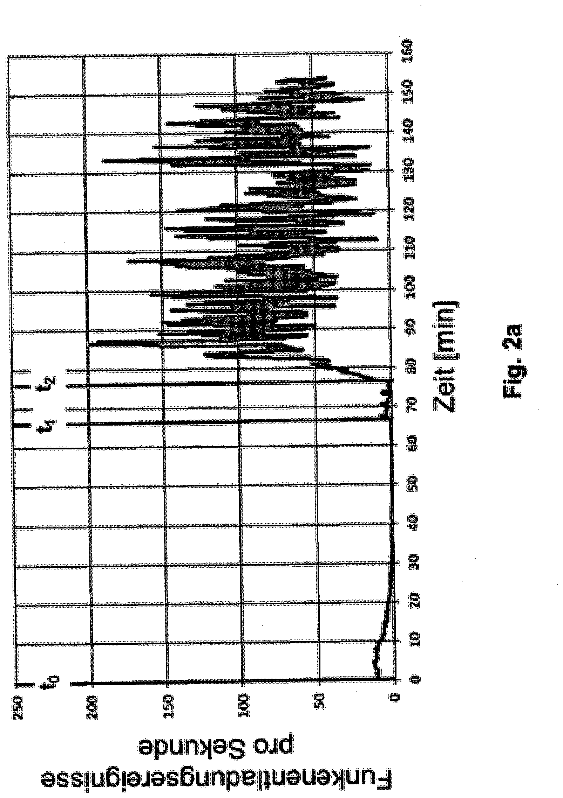

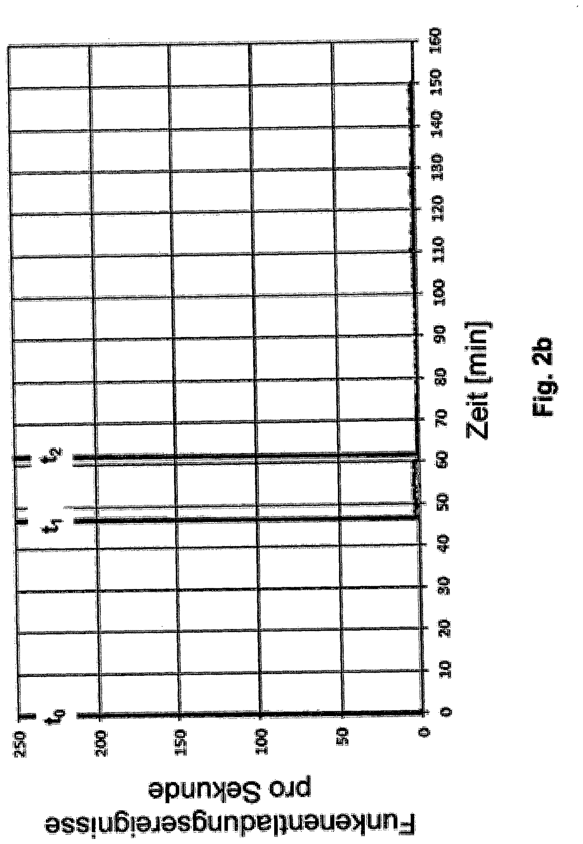

In der Figur 2 ist der zeitliche Verlauf der Funkenentladungen von zwei verschiedenen reaktiven HiPIMS-Prozessen dargestellt.

Der in der Fig. 2a dargestellte Verlauf gehört zu einem HiPIMS-Prozess, bei dem Aluminium Targets mit einer Aluminiumkonzentration in Atom% von 99.9 at% verwendet wurden. Die verwendete Sputter-Leistungsdichte am Target betrug 300 W/cm². Argon wurde zuerst in die Beschichtungskammer eingelassen und als Arbeitsgas verwendet. Der Prozess wurde druckgeregelt durchgeführt bei einem gesamten Prozessdruck von 0.6 Pa. Für die Konditionierung des Targets wurde der Sputter-Prozess am Target bei einer Zeit **t₀** hinter einer Blende (Shutter) in der Argonatmosphäre gestartet. Nach der Target-Konditionierungszeit wurde bei einer Zeit **t₁** Sauerstoff in die Beschichtungskammer eingelassen und der Sauerstoffpartialdruck wurde bei 100 mPa gehalten. Bei einer Zeit **t₂** wurde die Blende vom Target weggezogen, sodass ab diesem Zeitpunkt die Abscheidung der Oxidschicht auf die zu beschichtenden Substratoberflächen anfangen konnte. Wie es in der Fig. 2a zu sehen ist, wurden starke und häufige Funkenentladungen während der Abscheidung der Oxidschicht festgestellt. Nach der Durchführung des HiPIMS-Prozesses haben die Erfinder die verwendeten Targets untersucht und klare Spuren von Funkenentladungen auf dem Randbereich der Targetoberfläche festgestellt.

Der in der Fig. 2b dargestellte Verlauf gehört zu einem HiPIMS-Prozess, bei dem Aluminium-Chrom Targets mit einer Aluminium-Chrom-Konzentration in Atom% von 50:50 at% verwendet wurden. Ansonsten wurden gleiche Prozessparameter wie im oben beschriebenen HiPIMS-Prozess und derselbe Prozessverlauf verwendet. Wie es in der Fig. 2b zu sehen ist, konnten diesmal keine klaren Funkenentladungen während der Abscheidung der Oxidschicht festgestellt werden. Die Erfinder haben ebenfalls die verwendeten Targets nach der Durchführung des HiPIMS-Prozesses untersucht, aber diesmal konnten sie keine Spuren von Funkenentladungen auf dem Randbereich der Targetoberfläche feststellen.

Nach diesen Untersuchungen sind dann die Erfinder plötzlich auf die Idee gekommen ein Target zu konzipieren, welches neben einem Material **M₁** zur Abscheidung der gewünschten Schicht mindestens im Randbereich der Targetoberfläche ein zweites Material **M₂** umfasst, das bei einer reaktiven Sputter- oder HiPIMS-Schichtabscheidung nicht zur Abbildung von Funkenentladungen neigt.

Im Folgenden werden mehrere bevorzugte Ausführungsformen von Targets mit Gestaltungen gemäss der vorliegenden Erfindung, durch die eine reduzierte Neigung zu elektrischen Durchschlägen bzw. eine reduzierte Neigung zur Abbildung von Funkenentladungen erreicht wird, und somit eine prozessstabile Abscheidung von elektrisch-isolierenden Schichten mittels reaktiven Sputter- oder HiPIMS-Prozessen ermöglicht wird.

Die Figur 3 zeigt eine skizzierte Darstellung eines Querschnitts eines Targets. Das erste Material **M₁**, welches zur Erzeugung der gewünschten Schicht verwendet werden möchte, befindet sich im Kernbereich des Targets. Das zweite Material **M₂,** welches eine geringere Neigung zur Abbildung von Funkenentladung bei reaktiven Sputter-Prozessen im Vergleich mit **M₁** aufweist, ist im Verbund mit dem ersten Material **M₁** an der Randzone des Bereiches des Targets mit höherer Erosion gelegen. Wie bereits oben erwähnt, eine höhere Anfälligkeit zur Abbildung von Funkenentladung ist besonders zu erwarten in den Bereichen der Targetoberfläche, in denen eine geringe Erosion beim Sputter-Prozess stattfindet, bzw. wo keine Racetrack zu finden ist. Deshalb, genau dort sollte das zweite Material **M₂** gelegen sein. Da die Bereiche des Targets, wo das zweite Material **M₂** gemäss der vorliegenden Erfindung vorhanden sein soll, durch eine geringe Sputter-Rate gekennzeichnet sind, sollte der Anteil von diesem Material **M₂** in der Zusammensetzung der auf die zu beschichtenden Substrate abgeschiedenen Schichten sehr gering sein. Die Dimension der Fläche des hier als Kernbereich des Targets bezeichneten Targetbereichs kann, wie in Fig. 3 gezeigt, über die Dicke des Targets variieren. In Fig. 3 ist auch ein Plasmabereich 3 dargestellt, welcher durch die Magnetfelder des Magnetron geformt wird und mindestens am Randbereich des Targets die Materialien **M₁** und **M₂** überlappt.

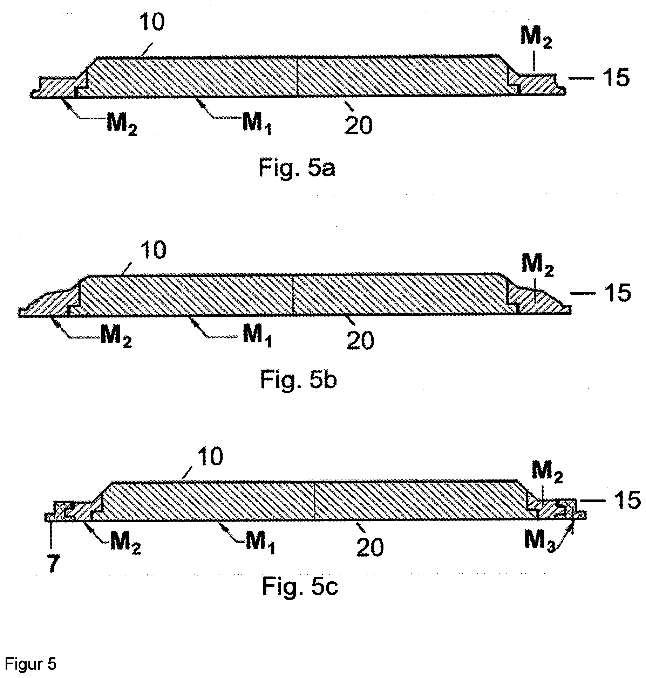

Bei manchen Versuchen wurde festgestellt, dass es von Vorteil sein kann, wenn die Dimension des Target-Kernbereiches aus Material **M₁** am Vorderbereich bzw. am Oberflächenbereich **10** des Targets kleiner als im Hinterbereich **20** des Targets ist, wie es beispielweise in den Figuren 3 und 5 schematisch dargestellt ist.

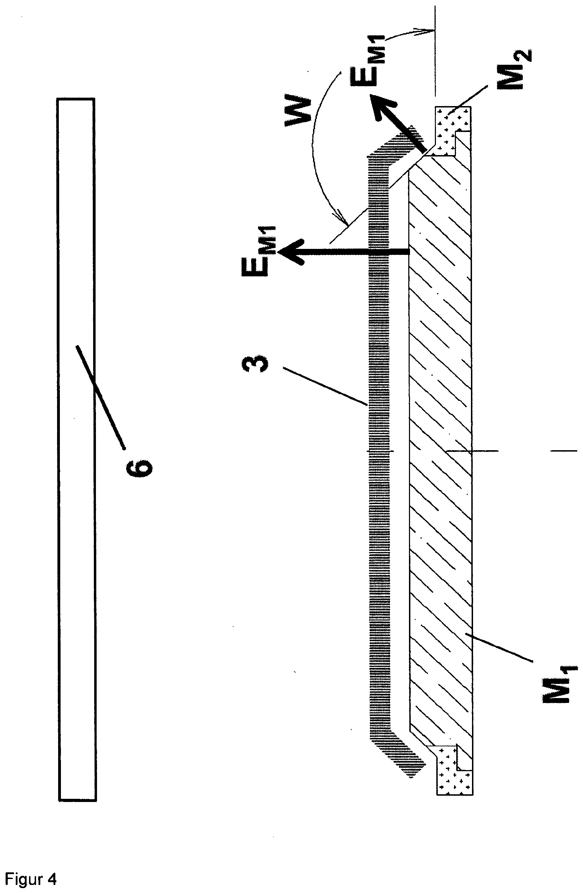

Die Figur 4 zeigt eine skizzierte Darstellung eines Querschnitts eines Targets gemäss der vorliegenden Erfindung. Um zu vermeiden, dass die Konzentration vom zweiten Material **M₂** so hoch wird, dass die Schichteigenschaften der durch diese Methode abgeschiedenen Schichten beeinträchtigt werden, wird das Target derart gestaltet, dass es einen angestellten Winkel **W** im "Vermischungsbereich" des Target, wo das erste und zweite Material vorhanden sind, aufweist. Durch den Anstellwinkel **W** wird das zweite Material **M₂,** welches für den Schichtaufbau unerwünscht ist, selektiv weggeblendet. Mit den Pfeilen **E_{M1}** und **E_{M2}** werden jeweils in Fig. 4 die bevorzugten Emissionsrichtungen des ersten Materials **M₁** und des zweiten Materials **M₂** gezeigt, welche durch die Verwendung eines Targets gemäss dieser Ausführungsform der vorliegenden Erfindung zu erwarten sind. In der Fig. 4 ist auch ein zu beschichtendes Substrat 6 als Beispiel gezeichnet.

Die Figur 5 zeigt jeweils drei skizzierte Darstellungen der Querschnitte von drei Targets, welche gemäss drei weiteren bevorzugten Ausführungsformen der vorliegenden Erfindung konzipiert wurden.

Die Fig. 5a zeigt eine Variation der bereits in Figur 4 dargestellten Ausführungsform. Gemäss dieser Variation umfasst das Target im seitlichen Randbereich **15** mindestens eine Vertiefung, um das Befestigen des Targets in der Beschichtungsanlage zu vereinfachen. Gemäss dieser Ausführungsform umfasst die Abschrägung vorzugsweise das Interface zwischen den Materialien **M₁** und **M₂.**

Die Fig. 5b zeigt eine Ausführungsform, bei der das Target derart gestaltet ist, dass es zwei Abschrägungen aufweist. Dabei wird eine noch geringere Redeposition bzw. ein noch geringeres Wachstum eines aus der Reaktion vom Targetmaterial mit Reaktivgas resultierenden Filmes auf die Targetoberfläche im Bereich B_{M1} erreicht. Vorzugsweise werden auch, wie in Fig. 5b gezeigt, die kantigen Bereiche, die am Anfang und/oder am Ende jeder Abschrägung nach der entsprechenden Anfertigung vorhanden sein können, abgerundet, um mögliche geometrisch bedingte Funkenentladungen oder Kurzschlüsse zu vermeiden.

Die in Fig. 5c dargestellte Ausführungsform zeigt ein erfindungsgemässes Target, bei dem einen Bajonethalter **7,** bspw. einen Bajonetring, zur Halterung des Targets während des Sputter-Prozesses verwendet wird, wobei der Bajonethalter **7** aus einem dritten Material **M₃** hergestellt ist, welcher vorzugsweise auch bei hohen Temperaturen eine gute mechanische Stabilität aufweist.

Da die Herstellung von Aluminiumoxidschichten (Al₂O₃) speziell eine grosse Herausforderung bezüglich Prozessstabilität darstellt, haben die Erfinder Aluminiumoxidschichten mittels HiPIMS-Prozessen und unter Verwendung von erfindungsgemäss-gestalteten Targets abgeschieden, um die Verbesserung hinsichtlich Prozessstabilität festzustellen.

Als Beispiel wird hier über die Ergebnisse bei einem der erfindungsgemäss durchgeführten Versuche berichtet:
Die Aluminiumoxidschichten mittels eines reaktiven HiPIMS-Prozesses, welcher bei folgenden Prozessparametern durchgeführt wurde:
- Arbeitsgas: Argon
- Reaktivgas: Sauerstoff
- Prozessdruck: 0.6 Pa
- Sauerstoffpartialdruck: 100 mPa
- Leistungsdichte: 300 W/cm²
- Target nach der in Fig. 5a dargestellten Ausführungsform der vorliegenden Erfindung mit M₁ = Aluminium in einer Konzentration von 99.9 at% (Al 99.9 in at%) und M₂ = Aluminium und Chrom jeweils in einer Konzentration von 50 at% (AlCr 50:50 in at%)

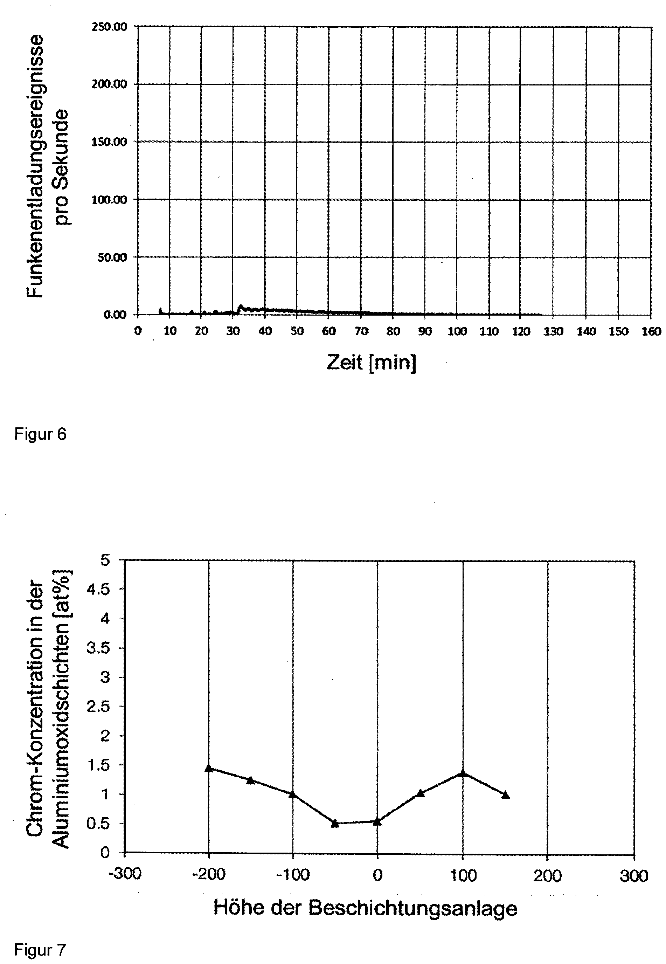

Der zeitliche Verlauf von störenden Funkenentladungen bei diesem Prozess ist in der Figur 6 dargestellt. Keine relevanten Funkenentladungen konnten während der erfindungsgemässen reaktiven HiPIMS-Abscheidung der elektrisch-isolierenden Aluminiumoxidschichten detektiert werden. Der Belegungsbereich (d.h. die Bereiche des Targets mit erhöhter Belegung mit dem aus der Reaktion vom Targetmaterial und Reaktivgas resultierten Film) zeigten kaum Funkenentladungsspuren. Der "Mischungsbereich" (auch oben "Vermischungsbereich" genannt), bei dem das erste Material Al und das zweite Material AlCr nebeneinander liegen, konnte gleichmässig gesputtert werden. Das konnte man erkennen, indem man nur sehr wenig Aluminiumoxid-Belegung der Targetoberfläche im "Mischungsbereich" detektiert hat. Der hier genannte "Mischungsbereich" umfasst die neben dem Interfacebereich zwischen **M₁** und **M₂** liegenden Oberflächenbereiche, und besonders in diesem Fall den kompletten Oberflächenbereich der an der Targetoberfläche vorhandenen Abschrägung. Mit dem Begriff Aluminiumoxid-Belegung ist hier der elektrisch-isolierende Aluminiumoxid-Film gemeint, der aus der Reaktion zwischen dem Reaktivgas (in diesem Fall Sauerstoff) und dem ersten Material M₁ (in diesem Fall Aluminium) resultiert. Aluminiumchromoxid-Belegung der Targetoberfläche konnte am Randbereich der Targetoberfläche detektiert werden, aber aufgrund der höheren elektrischen Leitfähigkeit, im Vergleich mit Aluminiumoxid, hat diese Belegung zu keinen Prozessinstabilitäten aufgrund von störenden Funkenentladungen geführt.

Die Chrom-Konzentration in den abgeschiedenen Aluminiumoxidschichten war kleiner als 1.5 at%, wie es in der Fig. 7 gezeigt ist. Somit wurden die Schichteigenschaften der Aluminiumoxidschichten nicht beeinträchtigt. Fig. 7 zeigt die gemessene Chrom-Konzentration von den Aluminiumoxidschichten, die auf Substraten abgeschieden wurden, welche in verschiedenen Positionen über die Höhe der Beschichtungskammer verteilt waren. Der Punkt 0 in der horizontalen Achse ist in diesem Beispiel zu verstehen als die Ebene in der vertikalen Richtung der Beschichtungsanlage (mit anderen Worten: die Höhe in der Beschichtungsanlage), bei der die Targetsmitte sich befindet.

## Patentansprüche

1. Target für reaktive Sputter-Abscheidung von elektrisch isolierenden Schichten in einer Beschichtungskammer, **dadurch gekennzeichnet, dass** das Target mindestens im Oberflächenbereich (10) mindestens einen ersten Bereich (B_{M1}) und einen zweiten Bereich (B_{M2}) umfasst, wobei
• der erste Bereich (B_{M1}) aus einem ersten Material (M₁) gebildet ist, welches aus einem Element oder mehreren Elementen besteht, welche mit einem Reaktivgas derart reagieren können, dass das aus der Reaktion resultierende M₁-umfassende Verbundmaterial der Zusammensetzung des zur Beschichtung der zu beschichtenden Substrate gewünschten Schichtmaterials entspricht, und
• der zweite Bereich (B_{M2}) aus einem zweiten Material (M₂) gebildet ist, welches aus einem Element oder mehreren Elementen besteht, welche gegenüber dem oben erwähnten Reaktivgas inert sind, oder mit dem oben erwähnten Reaktivgas derart reagieren können, dass das aus der Reaktion resultierende M₂-umfassende Verbundmaterial eine höhere elektrische Leitfähigkeit im Vergleich mit dem M₁-umfassenden Verbundmaterial aufweist, und
• das zweite Material (M₂) sich von dem ersten Material (M₁) mindestens in einem Element unterscheidet, wobei die Targetoberfläche (10) mindestens eine Abschrägung aufweist, welche durch einen angestellten Winkel (W) definiert ist, **dadurch gekennzeichnet, dass** im abgeschrägten Targetoberflächenbereich ein Vermischungsbereich vorhanden ist, bei dem das erste Material (M₁) und das zweite Material (M₂) nebeneinander vorhanden sind.

2. Target nach Anspruch 1, **dadurch gekennzeichnet, dass** der erste Bereich (B_{M1}) den Kernbereich des Targets umfasst.

3. Target nach einem der vorhergehenden Ansprüche 1 oder 2, **dadurch gekennzeichnet, dass** der zweite Bereich (B_{M2}) den Randbereich des Targets umfasst.

4. Methode zur Beschichtung von Substraten mit mindestens einer Schicht, welche unter Verwendung mindestens eines Targets nach einem der vorhergehenden Ansprüche 1 bis 3 abgeschieden wird.

5. Methode nach Anspruch 4, wobei die Schicht mindestens teilweise mittels eines reaktiven Sputterprozesses und/oder mindestens teilweise mittels eines reaktiven HiPIMS-Prozesses abgeschieden wird und wobei Reaktivgas beim Prozess verwendet wird, um die Schicht durch die Reaktion zwischen abgesputtertem Targetmaterial und Reaktivgas zu produzieren.

6. Methode nach Anspruch 5, wobei die Erosionsrate im Oberflächenbereich (10) des Targets während des Sputterprozesses und/oder HiPIMS-Prozesses am ersten Bereich des Targets (B_{M1}) grösser als am zweiten Bereich des Targets (B_{M2}) ist.

7. Methode nach Anspruch 6, wobei die Schicht elektrisch-isolierend ist.

8. Methode nach einem der vorhergehenden Ansprüche 5 bis 8, wobei die Schicht mindestens grösstenteils eine Zusammensetzung aufweist, welche der Zusammensetzung eines aus der Reaktion zwischen dem ersten Targetmaterial (M₁) und dem Reaktivgas resultierenden Verbundmaterials entspricht.

9. Methode nach einem der vorgehenden Ansprüche 5 bis 8, wobei das Reaktivgas Sauerstoff oder Stickstoff oder eine Mischung derselben umfasst.

10. Methode nach einem der vorgehenden Ansprüche 5 bis 9, wobei das erste Targetmaterial (M₁) mindestens grösstenteils Aluminium umfasst.

11. Methode nach einem der vorgehenden Ansprüche 5 bis 10, wobei das zweite Targetmaterial (M₂) Aluminium und Chrom umfasst.

12. Methode nach Anspruch 11, wobei das erste Material (M₁) Aluminium in einer Konzentration von mindestens 99.9 % in Atom% umfasst und die Schicht mindestens grösstenteils Aluminiumoxid umfasst.

13. Methode nach Anspruch 12, wobei das zweite Material (M₂) Aluminium und Chrom in einer Konzentration von 50:50 % in Atom% umfasst.

## Claims

1. A target for reactive sputter deposition of electrically insulating layers in a coating chamber, **characterized in that** the target at least in a surface region (10) comprising at least a first region (B_{M1}) and a second region (B_{M2}), wherein
• the first region (B_{M1}) is made of a first material (M₁), which is composed of one or more elements that can react with a reactive gas in such a way that an M₁-containing composite material resulting from the reaction corresponds to the composition of the desired layer material for coating substrates that are to be coated, and
• the second region (B_{M2}) is made of a second material (M₂), which is composed of one or more elements that are inert against the above-mentioned reactive gas or that can react with the above-mentioned reactive gas in such a way that an M₂-containing composite material resulting from the reaction has a higher electrical conductivity in comparison to the M₁-containing composite material, and
• wherein the second material (M₂) differs from the first material (M₁) in at least one element, wherein the target surface (10) has at least one bevel, which is defined by a set angle (W) **characterized in that** in the beveled target surface region, there is a "mixing region" in which the first material (M₁) and the second material (M₂) are situated next to each other.

2. The target according to claim 1, **characterized in that** the first region (B_{M1}) includes the core region of the target.

3. The target according to claim 1 or 2, **characterized in that** the second region (B_{M2}) includes the edge region of the target.

4. A method for coating substrates with at least one layer that is deposited using at least one target according to one of the preceding claims 1 through 3.

5. The method according to claim 4, wherein the layer is deposited at least partially by means of a reactive sputtering process and/or at least partially by means of a reactive HiPIMS process and reactive gas is used in the process in order to produce the layer by means of the reaction between the sputtered target material and the reactive gas.

6. The method according to claim 5, wherein the erosion rate in the surface region (10) of the target during the sputtering process and/or HiPIMS process is greater in the first region (B_{M1}) of the target than in the second region (B_{M2}) of the target.

7. The method according to claim 6, wherein the layer is electrically insulating.

8. The method according to one of the preceding claims 5 through 7, wherein at least most of the layer has a composition that corresponds to the composition of a composite material resulting from the reaction between the first target material (M₁) and the reactive gas.

9. The method according to one of the preceding claims 5 to 8, wherein the reactive gas comprises oxygen or nitrogen or a mixture thereof.

10. The method according to one of the preceding claims 5 to 9, wherein the first target material (M₁) comprise at least mostly aluminum.

11. The method according to one of the preceding claims 5 to 10, wherein the second target material (M₂) comprises aluminum and chromium.

12. The method according to claim 11, wherein the first material (M₁) comprises aluminum in a concentration of at least 99.9 % in atomic % and the layer comprises at least mostly aluminum oxide.

13. The method according to claim 14, wherein the second material (M₂) comprises aluminum and chromium in a concentration of 50:50 % in atomic %.

## Revendications

1. Cible pour le dépôt par pulvérisation cathodique réactive de couches électriquement isolantes dans une chambre de revêtement,
**caractérisée en ce que** la cible comprend, au moins dans la zone de la surface (10), au moins une première zone (B_{M1}) et une deuxième zone (B_{M2}),
dans laquelle
• la première zone (B_{M1}) est formée d'un premier matériau (M₁) qui consiste en un élément ou en plusieurs éléments pouvant réagir avec un gaz réactif de telle sorte que le matériau composite comprenant du M₁ résultant de la réaction correspond à la composition du matériau de couche souhaité pour le revêtement des substrats à revêtir, et
• ladite seconde zone (B_{M2}) est formée d'un second matériau (M₂) constitué en un élément ou en plusieurs éléments inertes audit gaz réactif ou capables de réagir avec ledit gaz réactif de telle sorte que le matériau composite comprenant du M₂ résultant de ladite réaction présente une conductivité électrique plus élevée par comparaison avec le matériau composite comprenant du M₁, et
• le second matériau (M₂) diffère du premier matériau (M₁) par au moins un élément, la surface cible (10) ayant au moins un biseau défini par un angle ajusté (W),
**caractérisée en ce que** dans la zone de surface cible biseautée se trouve une zone de mélange dans laquelle le premier matériau (M₁) et le second matériau (M₂) sont présents l'un à côté de l'autre.

2. Cible selon la revendication 1,
**caractérisée en ce que**
la première zone (B_{M1}) comprend la zone centrale de la cible.

3. Cible selon l'une des revendications précédentes 1 ou 2,
**caractérisée en ce que**
la seconde zone (B_{M2}) comprend la zone marginale de la cible.

4. Procédé de revêtement de substrats par au moins une couche déposée en utilisant au moins une cible selon l'une des revendications précédentes 1 à 3.

5. Procédé selon la revendication 4,
dans lequel
la couche est déposée au moins partiellement à l'aide d'un processus de pulvérisation cathodique réactive et/ou au moins partiellement à l'aide d'un processus HiPIMS réactif, le processus utilisant un gaz réactif pour produire la couche par la réaction entre le matériau cible pulvérisé et le gaz réactif.

6. Procédé selon la revendication 5,
dans lequel
le taux d'érosion dans la zone de surface (10) de la cible pendant le processus de pulvérisation cathodique et/ou pendant le processus HiPIMS sur la première zone de la cible (B_{M1}) est supérieur à celui sur la seconde zone de la cible (B_{M2}).

7. Procédé selon la revendication 6,
dans lequel
la couche est électriquement isolante.

8. Procédé selon l'une des revendications précédentes 5 à 7,
dans lequel
la couche comprend au moins majoritairement une composition qui correspond à la composition d'un matériau composite résultant de la réaction entre le premier matériau de cible (M₁) et le gaz réactif.

9. Procédé selon l'une des revendications précédentes 5 à 8,
dans lequel
le gaz réactif contient de l'oxygène ou de l'azote ou un mélange de ceux-ci.

10. Procédé selon l'une des revendications précédentes 5 à 9,
dans lequel
le premier matériau de cible (M₁) contient au moins majoritairement de l'aluminium.

11. Procédé selon l'une des revendications précédentes 5 à 10,
dans lequel
le second matériau de cible (M₂) contient de l'aluminium et du chrome.

12. Procédé selon la revendication 11,
dans lequel
le premier matériau (M₁) contient de l'aluminium dans une concentration d'au moins 99,9 % en pourcentage atomique et la couche contient au moins majoritairement de l'alumine.

13. Procédé selon la revendication 12,
dans lequel
le second matériau (M₂) contient de l'aluminium et du chrome dans une concentration de 50:50 en pourcentage atomique.
